Europäisches Patentamt

European Patent Office

Office européen des brevets

(11) Veröffentlichungsnummer : **0 452 647 B1**

(12) **EUROPÄISCHE PATENTSCHRIFT**

(45) Veröffentlichungstag der Patentschrift :
**08.06.94 Patentblatt 94/23**

(21) Anmeldenummer : **91103091.4**

(22) Anmeldetag : **01.03.91**

(51) Int. Cl.⁵ : **C23C 14/50**, F16C 33/14

(54) Vorrichtung zur Halterung und Kühlung nebeneinander angeordneter Werkstücke and Träger für mehrere Vorrichtungen.

(30) Priorität : **20.04.90 CH 1351/90**

(43) Veröffentlichungstag der Anmeldung :
**23.10.91 Patentblatt 91/43**

(45) Bekanntmachung des Hinweises auf die
Patenterteilung :
**08.06.94 Patentblatt 94/23**

(84) Benannte Vertragsstaaten :
**AT DE ES FR GB IT**

(56) Entgegenhaltungen :
**EP-A- 0 272 447**
**DE-A- 3 717 712**

(73) Patentinhaber : **BALZERS
AKTIENGESELLSCHAFT
FL-9496 Balzers (LI)**

(72) Erfinder : **Bergmann, Erich
Sarganserstrasse 58
CH-8887 Mels (CH)**
Erfinder : **Zäch, Martin
Unterm Schloss
FL-9496 Balzers (LI)**
Erfinder : **Kunz, Anton
Gufer 34
FL-9497 Triesenberg (LI)**

(74) Vertreter : **Keller, René, Dr. et al
Patentanwälte Dr. René Keller & Partner
Postfach 12
Marktgasse 31
CH-3000 Bern 7 (CH)**

**Beschreibung**

**Vorrichtung zur Halterung und Kühlung nebeneinander angeordneter Werkstücke und Träger für mehrere Vorrichtungen.**

Die Erfindung betrifft eine Vorrichtung zur Halterung und Kühlung nebeneinander angeordneter Werkstücke gemäß dem Oberbegriff des Patentanspruchs 1 und gemäß Patentanspruch 9 einen Träger mit mehreren Vorrichtungen.

Zur Herstellung eines in der EP-A 0 272 447 beschriebenen Verbundwerkstoffes als Gleitschicht auf Lagerschalen können diese entweder innerhalb der Vakuumkammer in eine dort befindliche, mit einem Kühlsystem verbundene Vorrichtung oder sofern die Vorrichtung aus der Vakuumkammer ausbaubar ist, in jene außerhalb der Vakuumkammer eingesetzt werden. Wurde die Vorrichtung aus der Vakuumkammer herausgeschraubt, so war dies einerseits zeitaufwendig und mühsam; es mußte außerdem darauf geachtet werden, daß keinerlei Kühlflüssigkeit in die Vakuumkammer hineinlief. Ein Einlegen der Werkstücke in der Vakuumkammer, um ein Auslaufen der Kühlflüssigkeit zu vermeiden, war möglich, jedoch wurde hierdurch die Durchlaufzeit pro beschichtetes Werkstück aufgrund der Stillstandszeit der Vakuumbeschichtungskammer erhöht.

Eine in der DE-OS 37 17 712 beschriebene Vorrichtung gestattete ein Einlegen der Werkstücke in einen Werkstückhalter außerhalb der Vakuumbeschichtungskammer. Dabei war im Werkstückhalter ein mit einem Kühlmittel gefüllter, sich annähernd über die ganze Auflagefläche der Lagerschalen erstreckender Hohlraum als Wärmespeicher vorhanden. Besondere Vorkehrungen wurden getroffen, um die vom Wärmespeicher aufgenommene Wärme während des Beschichtungsvorganges an einem Kopfteil der Werkstückhalterung abzuführen. Zur Verbesserung der Temperaturkonstanz während des Beschichtungsvorganges wurde als Auflagefläche für die Lagerschalenrohlinge eine Metallschale mit einem guten Wärmeübergang, der durch Lamellen, Drähte oder Streifen erreicht wurde, verwendet.

Die in der DE-OS 37 17 712 beschriebene Vorrichtung gestattet zwar ein Einlegen der Werkstücke außerhalb der Vakuumkammer, war jedoch schwer und unhandlich.

Der Erfindung liegt die Aufgabe zugrunde, eine Vorrichtung zur Aufnahme von Werkstücken, insbesondere Lagerschalen zu schaffen, welche die Stillstandszeiten der Vakuumkammer unter Gewährleistung einer guten Beschichtungsqualität reduziert.

Die erfindungsgemäße Lösung dieser Aufgabe hinsichtlich der Vorrichtung ist Gegenstand des Patentanspruchs 1 und hinsichtlich eines Trägers mit mehreren Vorrichtungen Gegenstand des Patentanspruchs 9. Gegenstand der Ansprüche 2 bis 8 sind bevorzugte Ausführungsformen der erfindungsgemäßen Vorrichtung.

Im folgenden werden Beispiele der erfindungsgemäßen Vorrichtung und des Trägers anhand von Zeichnungen näher erläutert. Es zeigen:

Fig. 1 eine Draufsicht auf die Stirnseite einer Vorrichtung mit sechs an einem drehbaren Träger befestigten Kühlkörper-/Werkstückhaltepaaren, wobei, um ein Überladen der Darstellung zu vermeiden, nur zwei Paare dargestellt sind,

Fig. 2 einen Querschnitt durch ein Kühlkörper-/Werkstückhaltepaar der Vorrichtung,

Fig. 3 eine Draufsicht auf den Kühlkörperteil des in **Figur 1** und **2** dargestellten Kühlkörper-/Werkstückhaltepaares,

Fig. 4 eine Teildraufsicht auf die Wärmeübertragungsfläche des Werkstückhalteteils des in **Figur 1** und **2** dargestellten Kühlkörper-/Werkstückhaltepaares, und

Fig. 5 eine Draufsicht auf die Stirnseite des Kühlkörper-/Werkstückhaltepaares mit einer Hebeleeinrichtung zum Anpressen der Werkstücke auf eine Auflagefläche des Werkstückhalteteils.

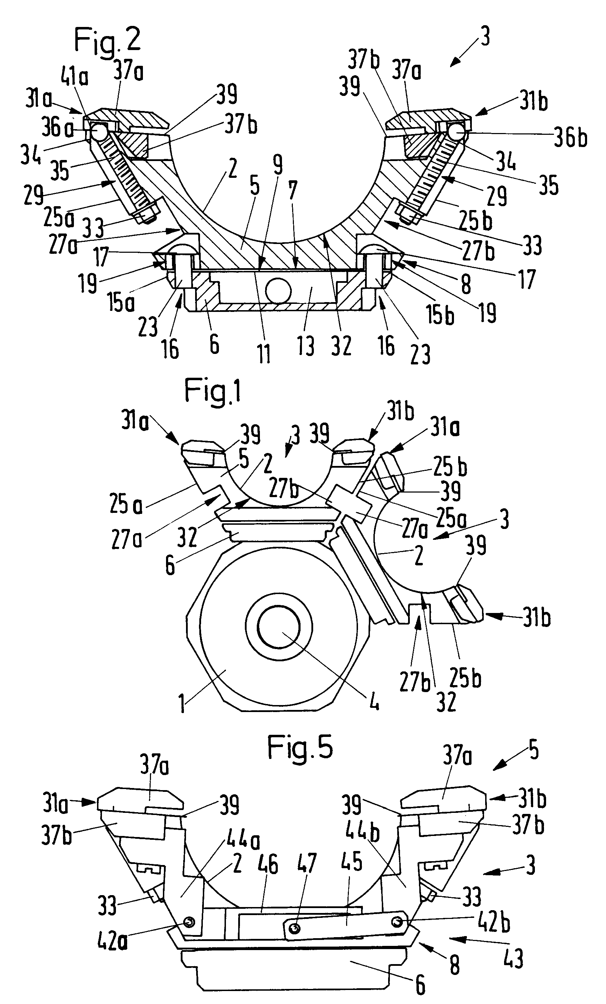

Die in einer Draufsicht in **Figur 1** dargestellte Vorrichtung zur Halterung und Kühlung nebeneinander angeordneter Lagerschalenrohlinge **2** zur Beschichtung in einer nicht dargestellten Vakuumkammer hat einen länglichen, sechseckigen Träger **1**, der drehbar um eine Drehachse **4** in der Vakuumkammer gelagert ist und an dem sechs Kühlkörper-/Werkstückhaltepaare **3** befestigt sind, von denen um die Darstellung nicht zu überladen, nur zwei dargestellt sind. Neun Träger **1** sind in der Vakuumkammer angeordnet. Jedes Kühlkörper-/Werkstückhaltepaar **3** besteht aus einem länglichen Werkstückhalte- und einem Kühlkörperteil **5** und **6**. Werkstückhalte- und Kühlkörperteil **5** und **6** sind ohne Werkzeug aufeinandergesteckt und können auch ohne Werkzeug wieder voneinander gelöst werden, wobei der Kühlkörperteil **6** immer fest mit dem Träger **1** verbunden bleibt. Im zusammengesteckten Zustand liegt der Werkstückhalteteil **5** mit seiner in seinem Bodenbereich **8** angeordneten Wärmeübertragungsfläche **7** auf einer der Wärmeübertragungsfläche **7** angepaßten Kühlfläche **9** des Kühlkörperteils **6**.

Die Kühlfläche **9** ist eine etwa 0,3 mm dicke Stahlfolie **11**, welche einen von Wasser als Kühlfluid durchströmten Hohlraum **13** abdeckt. Rostfreier Stahl als Material für die Kühlfläche **9**, wurde gewählt, da es einen guten Korrosionswiderstand aufweist. Überraschenderweise schmiegt sich die steife Stahlfolie **11** gut an die Wärmeübertragungsfläche 7 an, insbesondere wenn im Hohlraum 13 ein geringer Überdruck gegenüber der Umgebung herrscht, wobei sich dann die Kühlfläche 9 leicht konvex verformt. Der Hohlraum 13 ist mit einem Kühlmittelein- und einem -auslaß 14a bzw. 14b an nicht dargestellte Kühlleitungen im Träger 1 angeschlossen.

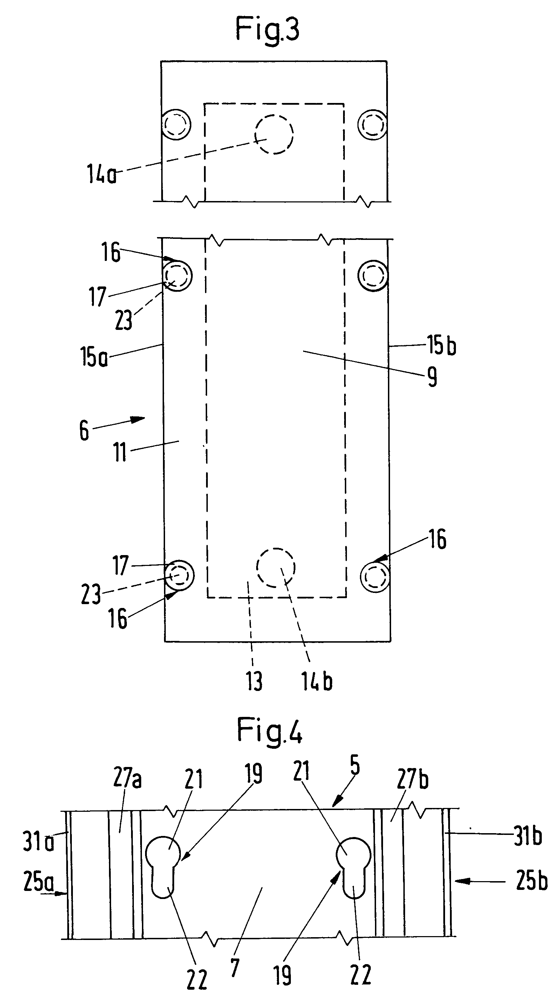

Entlang des Längsrandes 15a und 15b der Kühlfläche 9 sind annähernd im gleichen Abstand Nippel 16 angeordnet, wie in einem Querschnitt durch das Kühlkörper-/Werkstückhaltepaar 3 in **Figur 2** und in einer Draufsicht auf die Kühlfläche 9 in **Figur 3** zu sehen ist.

Die Köpfe 17 der Nippel 16 greifen, wie in **Figur 2** dargestellt ist, durch in **Figur 4** dargestellte, schlüssellochartige Öffnungen 19 in der Wärmeübertragungsfläche 7 des Werkstückhalteteils 5. Die Lage der Öffnungen 19 ist passend zur Lage der Nippel 16 auf der Kühlfläche 9 angeordnet. Die Öffnungen 19 sind derart ausgebildet, daß die Nippelköpfe 17 sämtlicher Nippel 16 durch jeweils den betreffenden großen Öffnungsteil 21 der Öffnung 19 steckbar sind. An den großen Öffnungsteil 21 schließt sich ein Schlitz 22 an, dessen Breite um eine Toleranz größer ist, als die Breite des Nippelhalses 23. Die Schlitztiefe ist um eine Toleranz größer als die Länge des Nippelhalses 23. Zur Verbindung des Werkstückhalteteils 5 mit dem Kühlkörperteil 6 werden die Nippelköpfe 17 durch die Öffnungsteile 21 gesteckt und der Werkstückhalteteil 5 in Richtung der Schlitze 22 gezogen, worauf die Nippelhälse 23 in den Schlitzen 22 bis zum Schlitzende gleiten. Da der Schlitz 22 schmaler als der Nippelkopf 17 ist, ist der Werkstückhalteteil 5 am Kühlkörperteil 6 sicher gehalten. Die der Wärmeübertragungsfläche 7 abgewandte Randfläche der Öffnung 19 verläuft parallel zu dieser; sie kann aber auch leicht ansteigend gegen das Schlitzende ausgebildet sein, um ein Verklemmen des Nippelkopfes 17 gegen das Schlitzende zu erreichen. Auf diese Schräge kann allerdings verzichtet werden, da die Kühlfläche 9, durch den im Hohlraum 13 herrschenden Druck elastisch leicht nach außen gewölbt ist.

Die Wärmeübertragungsfläche 7 ist so groß wie die Kühlfläche 9 ausgebildet und die Breite beider Flächen 7 und 9 annähernd so breit wie der Randabstand der zu beschichtenden Lagerschalenrohlinge 2. Oberhalb der Wärmeübertragungsfläche 7 erstreckt sich an jeder seitlichen Begrenzung 25a und 25b des Werkstückhalteteils 5 eine Längsnut 27a und 27b. Die Seiten 25a und 25b sind zur Wärmeübertragungsfläche 7 unter einem Winkel von annähernd einhundertzwanzig Grad angeordnet, damit sich sechs Werkstückhalteteile 5 am Träger 1 befestigen lassen. In den Längsnuten 27a und 27b befinden sich die Auflageflächen für die Nippelköpfe 17 und eine unten beschriebene Achshalterung 29 für auf- und zuklappbare Leisten 31a und 31b entlang der Ränder der seitlichen Begrenzung 25a und 25b, um die Lagerschalenrohlinge 2 in eine konkave halbzylindrische Auflagefläche 32 im Werkstückhalteteil 5 innig anliegend drücken zu können. Die Dimension der Längsnuten 27a und 27b ist so gewählt, daß sich unten beschriebene Muttern 33 gut einsetzen lassen. Durch die Längsnuten 27a und 27b ergibt sich eine Material- und damit Gewichtsersparnis, welche wie unten beschrieben ein einfaches Handling des Werkstückhalteteils 5 ermöglicht. Der Grundkörper des Werkstückhalteteils 5 ist aus Aluminium gefertigt, um vorteilhaft dessen gute Wärmeleitfähigkeit, gute Bearbeitbarkeit und geringes Gewicht auszunützen.

Die mit mehreren Muttern 33 in der Längsnut 27a bzw. 27b befestigte Achshalterungen 29, bestehen aus jeweils einer Gewindestange 35, welche an einer Achse 36a bzw 36b festgeschweißt ist. Die Achse 36a bzw. 36b liegt in jeweils einer Achspfanne 34 an der Seite 25a bzw. 25b des Werkstückhalteteils 5. Die Leiste 31a bzw. 31b hat einen Leistenober- und -unterteil 37a und 37b sowie einen Metallstreifen 39 aus Federstahl als Federelement. Der Metallstreifen 39 ist zwischen dem Leistenober- und -unterteil 37a und 37b eingeklemmt. Die Leistenober- und -unterteile 37a und 37b haben zu ihrer Lagerung an der Achse 36a bzw. 36b je eine Aussparung 41a und 41b (nur die Aussparung 41a ist in **Figur 2** sichtbar), welche die Achse 36a bzw. 36b mit einer Spielpassung umschließen. Die Leisten 31a und 31b sind mittels einer Hebeleinrichtung 43 gleichzeitig auf- und zuklappbar, wobei die Hebeleinrichtung 43 derart gestaltet ist, daß sie im zugeklappten Zustand selbstverriegelnd ist.

Die in **Figur 5** im verriegelten, zugeklappten Zustand dargestellte Hebeleinrichtung 43 ist über einen linken und rechten Leistenarm 44a und 44b mit den Leistenunterteilen 37b verschraubt. Am dem Leistenunterteil 37b abgewandten Ende der Leistenarme 44b und 44a ist ein balkenförmiger Hebel 45 bzw. ein U-förmiger Hebel 46 mit jeweils seinem einen Ende in einem Gelenk 42b bzw. 42a schwenkbar gelagert. Der Schenkelabstand des U-förmigen Hebels 46 ist so groß gewählt, daß die beiden Schenkel über die Seitenflächen des balkenförmigen Hebels 45 greifen. Auch in seiner Länge greift der Hebel 46 über den Hebel 45. Durch die Schenkel des Hebels 46 und durch das nicht am Leistenarm 44b gelagerte Ende des Hebels 45 verläuft eine Schwenkachse 47, welche im verriegelten Zustand der Hebeleinrichtung 43 annähernd in der Grundlinie des Bodenbereichs 8 liegt.

Zum Aufklappen wird der Hebel 46 am Ort der Schwenkachse 47 vom Bodenbereich 8 weggezogen.

Sollen Lagerschalenrohlinge 2, wie oben erwähnt, beschichtet werden, so werden sie außerhalb der Vakuumkammer bei aufgeklappten Leisten 31a und 31b in die Auflagefläche 32 des Werkstückhalteteils 5 nebeneinander eingelegt. Abhängig von der Breite der Lagerschalenrohlinge 2 und der Länge des Werkstückhalteteils 5 lassen sich typischerweise zwanzig Lagerschalenrohlinge 2 aus unlegiertem Werkzeugstahl mit einer im Sinterverfahren aufgebrachten 200 μm dicken Trägerschicht aus Bleibronze (CuPb 23Su4) einlegen.

Beim gleichzeitigen Zuklappen der Leisten **31a** und **31b** drücken die Metallstreifen **39** auf die Ränder der Lagerschalenrohlinge **2**, wodurch diese derart in die Auflagefläche **32** gedrückt werden, daß sie innig mit einem guten Wärmekontakt anliegen. Aufgrund der Federwirkung der Metallstreifen **39** werden geringe Maßunterschiede der Lagerschalenrohlinge **2** ausgeglichen. Wie oben dargelegt, können vierundfünfzig Werkstückhalteteile **5** an neun Trägern **1** bei einem Beschichtungsvorgang in der Vakuumkammer beschichtet werden.

Bereits von einem vorhergehenden Beschichtungsvorgang am Träger **1** befindliche Werkstückhalteteile **5** werden entnommen und durch mit unbeschichteten Lagerschalenrohlingen **2** bestückte ersetzt. Nach dem Aufstecken der Werkstückhalteteile **5** wird die Vakuumkammer geschlossen und der Beschichtungsvorgang mit einer an sich bekannten Kathodenzerstäubungsanlage gestartet.

Bei neun Trägern **1** mit je sechs Werkstückhalteteilen **5**, die mit je zwanzig Lagerschalenrohlingen **2** bestückt werden, wird mit einer Gesamtleistung von 120 kW bei einem Druck von 1,2 Pa in Argon in vollständiger Abwesenheit von Sauerstoff während acht Stunden beschichtet. Als Target wird eine Aluminiumzinnlegierung AlSn20Cu1 verwendet. Hierbei ist die Kühlwasseraustrittstemperatur um 25 °C höher als die Kühlwassereintrittstemperatur. Je nach gewünschter Härte wird in einem nicht dargestellten Wärmetauscher, wie folgend dargestellt, die Kühlwassereintrittstemperatur eingestellt:

```
Kühlwassereintrittstemperatur     Schichthärte im Scheitel
           10 °C                        150 - 170 HV
           30 °C                        130 - 140 HV
           60 °C                        100 - 120 HV
           80 °C                         70 -  90 HV
```

HV bedeutet Vickers Härte. Am Ende der Beschichtung wird eine Schichtdicke von 150 μm erreicht.

Anstelle die Lagerschalenrohlinge **2** direkt in die Auflagefläche **32** einzulegen, können zwischen Lagerschalenrohlinge **2** und Auflagefläche **32** zwei etwa 1 mm dicke, nicht dargestellte Teflonfolienstreifen eingelegt werden. Je eine Längsseite jedes Folienstreifens verjüngt sich zu einer Schneide. Beide Folienstreifen werden so auf die Auflagefläche **32** des während des Bestückens annähernd waagrecht liegenden Werkstückhalteteils **5** gelegt, daß sich ein Schlitz entlang des tiefsten Teiles der Auflagefläche **32** ergibt. Die Folienstreifen haften aufgrund ihrer Adhäsion auf der Auflagefläche **32**. Auf die Folienstreifen werden die Lagerschalenrohlinge **2** gelegt und, wie bereits oben beschrieben, mit den Leisten 31a und 31b eingespannt.

Die Teflonfolie ist ein guter Wärmeisolator. Die Lagerschalenrohlinge, **2** haben nur an ihrem Scheitel einen guten Wärmekontakt mit der Auflagefläche **32** alle anderen Teile sind durch die Teflonfolie wärmeisoliert. Aufgrund der Wärmeableitung nur am Scheitel der Lagerschalenrohlinge **2** steigt die Temperatur zu den Rändern der Rohlinge **2** hin an. Nach dem Beschichtungsvorgang haben sich am Scheitel der Lagerschalen **2** feine Partikel mit einer hohen Oberflächenhärte und zu den Rändern hin grobe Partikel mit entsprechend geringerer Oberflächenhärte abgeschieden.

Anstelle die Kühlflächentemperatur mittels durch den Hohlraum **13** strömendem Wasser einzustellen, kann sie auch durch ein nicht dargestelltes Peltierelement unterhalb der Kühlfläche **9** geregelt werden.

Da bereits beschichtete Lagerschalen **2** außerhalb der Vakuumkammer aus den Werkstückhalteteilen **5** herausgenommen werden, und anschließend unbeschichtete Lagerschalenrohlinge **2** neu eingesetzt werden, kann während des Bestückens der Werkstückhalteteilen **5** schon die Beschichtung von Lagerschalenrohlingen **2** in der Vakuumkammer erfolgen. Hierdurch läßt sich fortlaufend in der Vakuumkammer beschichten, wodurch sich die Durchlaufzeit bei der Herstellung von Lagerschalen **2** beträchtlich verkürzt.

Da der Kühlkörperteil **6** des Kühlkörper- und Werkstückhaltepaares **3** fest mit dem Träger **1** verbunden ist, läßt sich dieser unter optimaler Auslegung des Kühlkreislaufes an den Träger **1** anschließen. Ferner läßt sich durch Abkoppeln des Kühlkörperteils **6** vom Werkstückhalteteil **5** das Gewicht des beweglichen und transportierbaren Teils des Kühlkörper-/Werkstückhaltepaares **3** beträchtlich reduzieren. Eine Gewichtsreduzierung erlaubt eine einfachere und leichtere Handhabung und damit auch schnellere Bestückungszeiten. Als weiterer Vorteil ergibt sich eine größere Sauberkeit bei der Beschichtung, da einerseits keine Kühlflüssigkeit in die Vakuumkammer laufen kann, wie z. B. bei der Vorrichtung, wie sie bei dem in der EP-PA 0 272 447 beschriebenen Verfahren verwendet wird, und ferner die Zeit, in der die Vakuumkammer geöffnet ist, stark verkürzt ist.

Gegenüber der Längsbohrung in der Vorrichtung zur EP-PA 0 272 447 wird ein vom Kühlmittel durchflossener Hohlraum **13** verwendet, der mit einer gut wärmeleitenden dünnen Stahlfolie **11** als Kühlfläche **6**, wie oben beschreiben, flächig abgedeckt ist. Die Kühlfläche **6** steht über die große Wärmeübertragungsfläche **7** des Bodenbereichs **8** des Werkstückhalteteils **5** in gutem Wärmekontakt. Hierdurch kann der Durchfluß von Kühlmittel reduziert werden.

**Patentansprüche**

1.  Vorrichtung zur Halterung und Kühlung nebeneinander angeordneter Werkstücke, insbesondere Lagerschalenrohlinge **(2)**, während eines Beschichtungsvorganges in einer Vakuumbeschichtungskammer, **gekennzeichnet durch** wenigstens ein voneinander lösbares, längliches Kühlkörper-/Werkstückhaltepaar **(3)**, dessen länglicher Werkstückhalteteil **(5)** an einer Seite eine Auflagefläche **(32)** für die Werkstücke **(2)** und an der anderen Seite eine sich über die ganze Länge der Auflagefläche **(32)** erstreckende Wärmeübertragungsfläche **(7)** und dessen Kühlkörperteil **(6)** eine der Wärmeübertragungsfläche **(7)** angepaßte Kühlfläche **(9)** zur Ableitung der Wärme von der Wärmeübertragungsfläche **(7)** hat.

2.  Vorrichtung nach Anspruch 1, **dadurch gekennzeichnet,** daß der Kühlkörperteil **(6)** einen wenigstens annähernd an die ganze Kühlfläche **(9)** angrenzenden, von einem Kühlfluid durchströmbaren Hohlraum **(13)** hat.

3.  Vorrichtung nach Anspruch 1 oder 2, **dadurch gekennzeichnet,** daß der Werkstückhalteteil **(5)** ohne Verwendung eines Werkzeuges auf den Kühlkörperteil **(6)** aufsteckbar und wieder abnehmbar ist.

4.  Vorrichtung nach Anspruch 2, **dadurch gekennzeichnet,** daß die Kühlfläche **(9)** aus einer verformbaren Folie **(11)**, bevorzugt aus Stahl, gebildet ist, die den Hohlraum **(13)** begrenzt.

5.  Vorrichtung nach einem der Ansprüche 1 bis 4, **dadurch gekennzeichnet,** daß der Werkstückhalteteil **(5)** einen plattenartigen, die Wärmeübertragungsfläche **(7)** aufweisenden Bodenbereich **(8)** hat, dessen Breite und Länge mindestens annähernd der Breite und Länge der rinnenförmigen Auflagefläche **(32)** entspricht oder größer ist.

6.  Vorrichtung nach einem der Ansprüche 1 bis 5, **dadurch gekennzeichnet,** daß an beiden Längsrändern der Auflagefläche **(32)** je eine aufklapp- und verriegelbare Leiste **(31a, 31b)** zum Halten und Andrücken der Werkstücke **(2)** auf die Auflagefläche **(32)** angeordnet ist.

7.  Vorrichtung nach Anspruch 6, **dadurch gekennzeichnet,** daß, die Leiste **(31a, 31b)** mit einem Federelement **(39)** versehen ist, welches im verriegelten Zustand in den Werkstückhalteteil **(5)** eingelegte Werkstücke **(2)** innig gegen die Auflagefläche **(32)** des Werkstückhalteteils **(5)** preßt.

8.  Vorrichtung nach einem der Ansprüche 1 bis 7, **dadurch gekennzeichnet,** daß
    wärmeisolierende Folienstreifen im Randbereich auf der Auflagefläche **(32)** unter Freilassung deren zentrischen Bereichs, insbesondere sich zu einer Schneide in Richtung der Mittellinie der Auflagenfläche **(32)** verjüngende Teflonfolienstreifen, angeordnet sind, damit
    im wesentlichen nur der Scheitelbereich der Werkstücke **(2)** im direkten Wärmekontakt mit der Auflagefläche **(32)** steht, um
    während des Beschichtungsvorgangs einen Temperaturgradient quer zur Werkstückhalteteillängsrichtung auf den zu beschichtenden Werkstückflächen auszubilden.

9.  In einer Vakuumkammer drehbar gelagerter, länglicher Träger mit mehreren Vorrichtungen nach einem der Ansprüche 1 bis 8, um
    den herum mehrere Kühlkörperteile **(6)** je einer der Vorrichtungen parallel zur Drehachse **(4)** des Trägers angeordnet sind, wobei
    die seitlichen Begrenzungen **(25a, 25b)** jedes an einem der Kühlkörperteile **(6)** angebrachten Werkstückhalteteils **(5)** annähernd radial zur Drehachse **(4)** verlaufen.

## Claims

1. Device for the holding and cooling of closely arrayed production pieces, especially unfinished bearings (2), during a coating process in a vacuum chamber for the purpose, characterised in that it has at least one elongated separable cooling body/production piece-holder assembled pair (3), the elongated production piece-holding part (5) of which has on one side a carrying surface (32) for the production pieces (2) and on the other side a heat-transmitting surface (7) extending the entire length of the carrying surface (32), and the cooling-body part (6) of which has a cooling surface (9) adapted to the heat-transmitting surface (7), for conducting the heat from the heat-transmitting surface (7).

2. Device according to Claim 1, characterised in that the cooling-body part (6) has a cavity (13) running adjacent to at least most of the cooling surface (9) along its entire length, through which a cooling fluid can flow.

3. Device according to Claim 1 or 2, characterised in that the production piece-holding part (5) can be fitted to the cooling-body part (6) and removed again without the use of a tool.

4. Device according to Claim 2, characterised in that the cooling surface (9) is formed of a deformable foil (11), preferably of steel, which bounds the cavity (13).

5. Device according to one of Claims 1 to 4, characterised in that the production piece-holding part (5) has a bottom area (8) comprising the heat-transmitting surface (7), the breadth and length of which area correspond at least approximately to, or are greater than, the breadth and length of the grooved carrying surface (32).

6. Device according to one of Claims 1 to 5, characterised in that at each of the longitudinal edges of the carrying surface (32) a hinged strip (31a, 31b) for holding and pressing the production pieces (2) to the carrying surfaces (32) is disposed, which strip can be locked in position.

7. Device according to Claim 6, characterised in that the strips (31a, 31b) are provided with a spring element (39) which, when said strips are locked in position, presses production pieces (2), inserted into the production piece-holding part (5), inwardly against the carrying surface (32) of the production piece-holding part (5).

8. Device according to one of Claims 1 to 7, characterised in that
   heat-insulating foil strips, especially Teflon foil strips tapering to a sharp edge in the direction of the centre line of the carrying surface (32), are arranged at the edges of the carrying surface (32) whilst its central area is left free, so that
   essentially, only the tops of the production pieces (2) are in direct thermal contact with the carrying surface (32), so as to form a temperature gradient at right angles to the longitudinal direction of the production piece-holding part, which is effective across the production-piece surfaces to be coated.

9. Support mounted rotatably in a vacuum chamber, together with several devices according to one of Claims 1 to 8, around which support the
   several cooling-body parts (6) of the devices are arranged parallel to the axis of rotation (4) of the support, whereby
   the lateral boundaries (25a, 25b) of each production piece-holding part (5) fitted to one of the cooling-body parts (6) run approximately radially to the axis of rotation (4).

## Revendications

1. Dispositif pour la fixation et le refroidissement de pièces à usiner disposées côte à côte, notamment d'ébauches de coquilles de coussinet (2), pendant un procédé de revêtement dans une chambre de revêtement sous vide, caractérisé en ce qu'au moins une paire d'éléments de fixation de pièces/corps de refroidissement (3) allongés, détachables, l'élément de fixation de pièces longitudinal (5) possédant sur l'un de ses côtés une surface d'appui (32) pour les pièces à usiner (2) et sur l'autre côté une surface de transmission thermique (7) qui s'étend sur toute la longueur de la surface de support (32) et l'élément de corps de refroidissement (6) possédant une surface de refroidissement (9) adaptée à la surface de transmission de chaleur (7) pour faire dévier la chaleur provenant de la surface de transmission de chaleur (7).

2. Dispositif selon la revendication 1, caractérisé en ce que la partie de corps de refroidissement (6) possède une zone ou chambre creuse (13) limitrophe au moins approximativement de toute la surface de refroidissement (9), pouvant être traversée par un fluide de refroidissement.

3. Dispositif selon la revendication 1 ou 2, caractérisé en ce que la partie de fixation de la pièce à usiner (5) peut être enfichée et de nouveau enlevée sans utilisation d'outils sur la partie du corps de refroidissement (6).

4. Dispositif selon la revendication 2, caractérisé en ce que la surface de refroidissement (9) est formée par une feuille déformable (11) de préférence en acier, qui délimite la zone creuse (13).

5. Dispositif selon l'une des revendications 1 à 4, caractérisé en ce que la partie de fixation de la pièce à usiner (5) possède une zone de fond (8) présentant une surface de transmission de chaleur (7) en forme de plaque, zone de fond dont la largeur et la longueur correspondent au moins de façon approximative ou est supérieure à la largeur et à la longueur de la surface d'appui (32) en forme de chenal.

6. Dispositif selon l'une des revendications 1 à 5, caractérisé en ce que sur les deux bords longitudinaux de la surface d'appui (32) est respectivement agencé un listeau rabattable et verrouillable (31a, 31b) pour la fixation et la compression des pièces à usiner (2) sur la surface d'appui (32).

7. Dispositif selon la revendication 6, caractérisé en ce que le listeau (31a, 31b) est muni d'un élément à ressorts (39) qui à l'état verrouillé comprime dans la partie de fixation de pièces à usiner (5) des pièces à usiner introduites (2) intimement contre la surface d'appui (32) de la partie de fixation de pièces à usiner (5).

8. Dispositif selon l'une des revendications 1 à 7, caractérisé en ce que
des bandes ou lamelles thermo-isolantes sont agencées dans la partie marginale sur la surface d'apppui (32) en maintenant une réserve dans la partie centrale, notamment une bande en Téflon allant en s'amincissant pour former un tranchant dans la direction de la ligne médiane de la surface d'appui (32), afin que seule la zone de sommet des pièces à usiner (2) vienne sensiblement en contact thermique direct avec la surface d'appui (32) pour former pendant le processus de revêtement un gradient de température transversalement à la direction longitudinale de la partie de fixation de pièces à usiner sur les surfaces de pièces à usiner à revêtir.

9. Support longitudinal logé de façon rotative dans une chambre sous vide avec plusieurs dispositifs selon l'une des revendications 1 à 8,
autour duquel sont agencées plusieurs parties de corps de refroidissement (6) respectivement de l'un des dispositifs parallèlement à l'axe de rotation (4) du support,
les délimitations latérales (25a, 25b) de chaque partie de fixation de pièces à usiner (5) agencées sur l'une des parties de corps de refroidissement (6) s'étendant approximativement de façon radiale par rapport à l'axe de rotation (4).

Fig.2

Fig.1

Fig.5

# Fig.3

# Fig.4